(19) Europäisches Patentamt
European Patent Office
Office européen des brevets

(11) **EP 3 141 913 A1**

(12) **EUROPÄISCHE PATENTANMELDUNG**

(43) Veröffentlichungstag:
**15.03.2017 Patentblatt 2017/11**

(51) Int Cl.:
**G01R 15/20** (2006.01)      **G01R 15/14** (2006.01)

(21) Anmeldenummer: **15184216.8**

(22) Anmeldetag: **08.09.2015**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA**

(71) Anmelder: **Siemens Aktiengesellschaft**
**80333 München (DE)**

(72) Erfinder:
• **Benz, Georg**
  **90556 Cadolzburg (DE)**
• **Stoll, Jürgen**
  **90768 Fürth (DE)**

(54) **VORRICHTUNG ZUR MESSUNG EINES STROMS**

(57) Die Erfindung betrifft eine Vorrichtung (1) zur Messung eines Stroms (I), aufweisend eine Sensor-Anordnung (10) und eine Leiteranordnung (30), wobei die Leiteranordnung (30) einen Mess-Leiter (32) und zumindest einen Bypass-Leiter (34) aufweist und wobei die Leiteranordnung (30) zur Aufteilung des Stroms (I) in einen Mess-Strom (I1) und mindestens einen Bypass-Strom (12) ausgebildet ist. Zur flexiblen und effizienten Messung eines Stroms wird vorgeschlagen eine Sensor-Anordnung (10) derart bezüglich der Leiteranordnung (30) anzuordnen, dass zumindest ein Teil des Mess-Leiters (32) in einem Messbereich (11) der Sensor-Anordnung (10) angeordnet ist und wobei der Mess-Leiter (32) zum Leiten des Mess-Stroms (I1) ausgebildet ist und der Bypass-Leiter (34) zum Leiten des Bypass-Stroms (12) außerhalb des Messbereichs (11) der Sensor-Anordnung (10) ausgebildet ist.

FIG 1

**Beschreibung**

Die Erfindung betrifft eine Vorrichtung zur Messung eines Stroms aufweisend eine Sensor-Anordnung und eine Leiteranordnung, wobei die Leiteranordnung einen Mess-Leiter und zumindest einen Bypass-Leiter aufweist und wobei die Leiteranordnung zur Aufteilung des Stroms in einen Mess-Strom und mindestens einen Bypass-Strom ausgebildet ist. Die Erfindung betrifft weiter ein Heizungssystem mit einer derartigen Vorrichtung.

Eine derartige Vorrichtung kann in elektrischen Schaltungen zum Einsatz kommen, in denen eine einfache und zuverlässige Strommessung erforderlich ist. Des Weiteren kann die Vorrichtung dann zum Einsatz kommen, wenn eine Aufteilung eines Stroms vorteilhaft ist, weil er beispielsweise für bestehende Lösungen zu groß ist oder weitere Anforderungen an das Layout und/oder an das thermische Design zu erfüllen sind, so dass der Strom nicht in einem einzelnen Strompfad oder Leiter geführt werden soll.

Bisher ist es nötig, ausreichend dimensionierte Leiterblöcke zum Leiten des gesamten Stroms vorzusehen, die nicht oder nur schwer in eine Leiterplatte integriert werden können und aufwendig mit der Leiterplatte in einem oder mehreren weiteren Schritten verlötet werden müssen.

Der Erfindung liegt die Aufgabe zugrunde, eine Vorrichtung zur Messung eines Stroms anzugeben, die es flexibel und effizient ermöglicht, Ströme zu messen.

Diese Aufgabe wird durch eine Vorrichtung mit den im Anspruch 1 angegebenen Merkmalen gelöst.

Dazu wird eine Vorrichtung zur Messung eines Stroms vorgeschlagen, die eine Sensor-Anordnung und eine Leiteranordnung aufweist. Die Leiteranordnung weist einen Mess-Leiter und zumindest einen Bypass-Leiter auf und ist zur Aufteilung des Stroms in einen Mess-Strom und mindestens einen Bypass-Strom ausgebildet. Die Sensor-Anordnung ist derart bezüglich der Leiteranordnung angeordnet, dass zumindest ein Teil des Mess-Leiters in einem Messbereich der Sensor-Anordnung angeordnet ist. Der Mess-Leiter ist zum Leiten des Mess-Stroms ausgebildet und der Bypass-Leiter zum Leiten des Bypass-Stroms außerhalb des Messbereichs der Sensor-Anordnung ausgebildet. Die Sensor-Anordnung kann dabei ein handelsüblicher Hall-Sensor oder Hall-Effekt-Sensor-IC zur Strommessung sein. Es ist aber ebenso denkbar, dass eine eigene Sensor-Anordnung eigens für die Vorrichtung implementiert wird. Darüber hinaus können auch weitere Sensoren zum Einsatz kommen die nicht auf dem Hall-Effekt basieren und das zur Stromstärke im Mess-Leiter korrespondierende Magnetfeld anderweitig erfassen. Hier sind unter anderem magnetoresistive Sensoren denkbar die beispielsweise auf dem GMR-Effekt (englisch: **G**iant **M**agneto**R**esistance) beruhen.

Durch das Aufteilen des zu messenden Stroms in einen Mess-Strom und einen Bypass-Strom, kann der Mess-Strom so weit verringert werden, dass er entweder den Anforderungen des Layouts genügt oder beispielsweise ein potentiell günstigerer oder kleinerer Sensor mit einem niedrigeren maximal zulässigen Strom gewählt werden kann. Der Bypass-Leiter und damit der Bypass-Strom kann so weit außerhalb des Messbereichs der Sensor-Anordnung geführt werden, dass es hier keine oder eine nur vernachlässigbar kleine Einwirkung auf den Sensor gibt. Der Messbereich soll der Bereich sein, in dem die Sensor-Anordnung zur Erfassung von Strömen geeignet ist. Dies kann beispielsweise ein vom Hersteller eines Hall-Sensors oder vergleichbaren Sensors angegebener Bereich sein. Besonders vorteilhaft an dieser Anordnung ist, dass die Freiheitsgrade der Anordnung der Bypass-Leiter und des Mess-Leiters einem kompakten und einfacheren Design zugutekommen. Dadurch, dass der Mess-Strom durch die Aufteilung kleiner ist als der zu messende Gesamtstrom, können weniger leistungsfähige und/oder günstigere Bauteile verwendet werden.

In einer besonders vorteilhaften Ausführungsform ist die Sensor-Anordnung bezogen auf die Leiteranordnung derart angeordnet, dass ein Magnetfeld des zumindest einen stromdurchflossenen Bypass-Leiters im Messbereich der Sensor-Anordnung minimal ist. Wird im Betrieb der Vorrichtung der Bypass-Leiter von einem Strom durchflossen, so erzeugt dieser ein Magnetfeld. Es ist nun besonders vorteilhaft, wenn der Bypass-Leiter so angeordnet wird, dass das erzeugte Magnetfeld des Bypass-Leiters nicht oder kaum auf die Sensor-Anordnung einwirkt. Dies hat den Hintergrund, dass die Messungen des Stroms, der im Mess-Leiter fließt, über dessen Magnetfeld auf diese Weise nicht durch das Magnetfeld des Bypass-Leiters beeinflusst wird. Es ist ebenso denkbar, dass der Bypass-Leiter vom Messbereich der Sensor-Anordnung abgeschirmt wird. Dies kann durch eine geeignete Magnetschirmung geschehen. Da der Einfluss des Magnetfelds des Bypass-Leiters minimiert wird, wird das Mess-Ergebnis des Mess-Stroms durch den Mess-Leiter deutlich verbessert. Beispielsweise kann mit dem Biot-Savart-Gesetz ermittelt werden, dass das Magnetfeld einer in gleicher Richtung durchflossenen Stromschleife in seiner Mitte minimal bzw. gleich Null ist. Alternativ sind auch simulatorische Ermittlungen der Magnetfeldverteilung in der Leiteranordnung mit modernen computergestützten Entwurfsprogrammen denkbar.

In einer weiteren vorteilhaften Ausführungsform weisen der Mess-Leiter und der zumindest eine Bypass-Leiter gleiche oder ähnliche temperaturabhängige Materialeigenschaften auf. Insbesondere der mit einer Änderung der Temperatur veränderliche Widerstand ist hier zu nennen.

Eine gängige lineare Näherung des spezifischen temperaturabhängigen Widerstands $\rho_R(T)$ wird im Folgenden gezeigt. Dabei ist $\rho_{R,20°C}$ der üblicherweise angegebene spezifische Widerstand des Materials bei Referenztemperatur, in diesem Fall 20°C. $\Delta T$ ist die Abweichung von der Referenztemperatur und $\alpha$ ein ebenfalls materialabhängiger Temperaturkoeffizient, der den linearen Anstieg des spezifischen Widerstands mit der Temperatur beschreibt.

$$\rho_R(T) = \rho_{R,20°C} \cdot (1 + \alpha \cdot \Delta T)$$

Die Abhängigkeit des Widerstands R eines Leiters von seiner Länge l und Querschnittsfläche A ist mit dem spezifischen Widerstand $\rho_R(T)$ wie folgt definiert.

$$R(T) = \rho_R(T) \cdot \frac{l}{A}$$

Kombiniert man beide Gleichungen so erhält man den folgenden Zusammenhang.

$$R(T, l, A) = \rho_{R,20°C} \cdot (1 + \alpha \cdot \Delta T) \cdot \frac{l}{A}$$

Damit ist der Widerstand des Leiters neben den Materialabhängigen Parametern $\rho_{R,20°C}$ und $\alpha$ nur noch von dessen Querschnittsfläche und Länge abhängig. Das könnte heißen, dass der Mess-Leiter und der/die Bypass-Leiter vorteilhaft aus dem gleichen Material, wie z. B. Kupfer, oder zumindest einem Material mit dem gleichen temperaturabhängigen spezifischen Widerstand bestehen. Weiterhin soll hier mit ähnlichen Materialeigenschaften definiert sein, dass die Materialien nicht gleich sein müssen. Ähnlich sind sie dann, wenn die Materialeigenschaften, zumindest bei den im Betrieb einer solchen Vorrichtung auftretenden Temperaturschwankungen, die Genauigkeit der Messungen nicht außerhalb einer vorgebbaren Toleranz beeinflussen. Dies kann beispielsweise dann der Fall sein, wenn die temperaturbedingten Änderungen des Widerstands in einem zulässigen Temperaturbereich der Vorrichtung weitestgehend proportional zueinander sind. Dies ermöglicht das Verwenden von verschiedenartigen Materialien, die beispielsweise für bestimmte Anwendungsfälle besser geeignet sind. So ist es denkbar, dass als Bypass-Leiter ein Material zum Einsatz kommt, das eine höhere Stromtragfähigkeit bei einem niedrigen Querschnitt aufweist. Das Material des Mess-Leiters könnte dann beispielsweise auf die Messung optimiert sein. Da die Aufteilung des Stroms direkt von den Widerständen des Mess-Leiters und der Bypass-Leiter abhängig ist, verbessert diese Ausführungsform das Messergebnis dahingehend, dass eine Temperaturabhängigkeit der Messvorrichtung weitestgehend minimiert werden kann. Weichen die temperaturabhängigen spezifischen Widerstände zu stark voneinander ab, so kann eine ausreichende Messgenauigkeit nicht über weite Temperaturbereiche erreicht werden.

In einer weiteren Ausführungsform ist das Verhältnis einer ersten Querschnittsfläche des Mess-Leiters zu einer zweiten Querschnittsfläche des Bypass-Leiters in Abhängigkeit vom maximal zu messenden Strom und der von der Sensor-Anordnung maximal erfassbaren Strom gewählt. Wie eingangs bereits ausgeführt, sind die Widerstände der Leiter und damit auch die Aufteilung der Ströme maßgeblich von der Querschnittsfläche der jeweiligen Leiter abhängig. Je größer die Querschnittsfläche, desto geringer wird der Widerstand. So kann sichergestellt werden, dass die Sensor-Anordnung im optimalen Betriebspunkt arbeiten kann. Eine ineffiziente Überdimensionierung ist nicht notwendig und gleichzeitig sind die Querschnittsflächen optimal gewählt. Wird angenommen, dass sowohl Bypass-Leiter als auch Mess-Leiter demselben Temperaturniveau ausgesetzt sind und ein identisches oder ähnliches Material zum Einsatz kommt, so ist das Verhältnis der beiden Ströme nur noch von der Länge der Leiter und der Querschnittsflächen abhängig. Dies ermöglicht es, unter optimaler Ausnutzung des verfügbaren Bauraums, die Stromtragfähigkeit und die Messbarkeit des Stroms zu optimieren. Dies ermöglicht es, die Vorrichtung auch in Systemen mit limitierten Platzverhältnissen einzusetzen oder sogar in bestehende Schaltungen zu integrieren.

In einer besonders vorteilhaften Ausführungsform ist die Leiteranordnung in oder auf eine Leiterplatte, insbesondere in oder auf eine nach einem PCB-Verfahren gefertigte Leiterplatte, integriert. Mit PCB-Verfahren ist hier das sogenannte Printed-Circuit-Board-Verfahren gemeint. Es ist aber ebenso denkbar zur Fertigung der Leiter-Anordnung direkt auf oder in einer Leiterplatte weitere bekannte Verfahren zur Leiterplattenfertigung einzusetzen. Auf diese Art und Weise kann die Leiteranordnung direkt mit dem Layout der Schaltung, in der sie zum Einsatz kommen soll, entworfen werden. Dabei können direkt Anforderungen wie Temperatur- und/oder Leistungsverteilung berücksichtigt werden. Ein direktes Integrieren der Leiteranordnung in die Schaltung, in der ein Strom gemessen werden soll, hat den großen Vorteil, dass keine weiteren Strom-Messvorrichtungen vorgesehen werden müssen. Besonders vorteilhaft ist, dass bei Verwendung einer der angegebenen Vorrichtungen die Anforderungen an die Stromtragfähigkeit, die sich mit der gewählten Fertigungstechnologie innerhalb einer Leiterplatte ergeben, direkt berücksichtigt werden können.

In weiteren Ausführungsformen ist die Leiteranordnung symmetrisch bezüglich des Mess-Leiters aufgebaut und/oder der Mess-Leiter mittig zwischen zwei Bypass-Leitern angeordnet. Dies könnte beispielsweise mit einer Leiter-Anordnung realisiert werden, die einen Mess-Leiter und zwei Bypass-Leiter aufweist. Dies ist eine mögliche und einfache Ausführungsform, mit der die Sensor-Anordnung so angeordnet werden kann, dass das Magnetfeld das durch sie fließt vor allem oder ausschließlich vom Mess-Strom durch den Mess-Leiter stammt. Ist der Mess-Leiter nun alternativ oder zusätzlich mittig zwischen den Bypass-Leitern angeordnet, so ergibt sich nur noch der Abstand vom Mess-Leiter zum Bypass-Leiter als Größe, die beim Entwurf einer Leiteranordnung optimiert werden kann. Hier gilt es einen Kompromiss zu finden zwischen dem vorhandenen Bauraum und einem ausreichenden Abstand der Bypass-Leiter zur Sensor-Anordnung.

In einer weiteren Ausführungsform sind mindestens zwei Bypass-Leiter thermisch miteinander gekoppelt. Bei einer Temperaturdifferenz zwischen den Bypass-Leitern ändert sich das Verhältnis der Widerstände der Bypass-Leiter und damit die Aufteilung des Stroms. Die Aufteilung des Stroms mit mit einer Änderung des Magnetfelds einher kommen und beeinflusst daher die Messung. Eine gleichmäßige Temperaturverteilung zwischen den Bypass-Leitern eliminiert diesen Einfluss auf die Messung.

Analog werden in einer weiteren Ausführungsform mindestens der Mess-Leiter und ein Bypass-Leiter thermisch miteinander gekoppelt. Hier gilt ebenfalls, dass die Aufteilung des Stromes nicht durch eine temperaturabhängige Änderung des Verhältnisses der Widerstände des Mess-Leiters zu dem/den Bypass-Leiter/n auftreten soll. Eine thermische Kopplung kann hier dafür sorgen, dass auftretende Änderungen der Temperatur gleichmäßig auf alle Leiter verteilt werden. Bei einer thermischen Kopplung zwischen Bypass-Leitern und/oder Mess-Leitern kann es sich dabei um einen einfachen Kühlkörper, eine sogenannte Heat-Pipe oder weitere geeignete Maßnahmen handeln. Zusätzlich könnte bei bekannter Temperatur, beispielsweise durch eine Messung der Temperatur der thermischen Kopplung, eine Temperaturkompensation der gesamten Strom-Messung durchgeführt werden.

In weiteren vorteilhaften Ausführungsformen ist die Sensor-Anordnung als eine Hall-Sensor-Anordnung und/oder als eine GMR-Sensor-Anordnung ausgebildet. Je nach Anwendungsbereich und zu messenden Strom kann sich der breitere Arbeitspunkt der typischen Hall Sensoren als Vorteil herausstellen. Ist dagegen eine höhere Empfindlichkeit bzw. eine höhere Auflösung gefordert so könnte ein GMR Sensor seine Vorteile ausspielen. Damit soll keinerlei Wertung der Sensortechnologien verbunden sein und es kann durchaus Anwendungsgebiete geben in denen ein Hall Sensor eine höhere Auflösung und ein GMR Sensor den breiteren Arbeitspunkt / Arbeitsbereich bietet. Auch eine Kombination der beiden oder weiterer Technologien ist denkbar.

Die Aufgabe wird weiterhin durch ein Heizungssystem gelöst, aufweisend eine erfindungsgemäße Vorrichtung sowie mindestens ein Heizelement und eine Heizungssteuerung. Da die erfindungsgemäße Vorrichtung besonders unempfindlich gegenüber Temperaturschwankungen ist, eignet sie sich besonders zum Einsatz in modernen hochintegrierten industriellen Heizungssystemen oder industriellen Heizungssteuerungssystemen. Ein Heizelement kann dabei beispielsweise ein Infrarotstrahler, ein resisitives oder induktives Heizelement sein. Die Heizungssteuerung kann dabei die nötige Leistungselektronik und Ansteuerung derselben enthalten. Leistungselektronik und Ansteuerung können aber ebenso in getrennten Baugruppen realisiert sein.

Die Vorrichtung zur Messung eines Stroms kann beispielsweise in industriellen Heizungsanlagen zum Einsatz kommen. Hier wären jegliche Fertigungsprozesse zu nennen, bei denen ein genauer und exakt gesteuerter oder geregelter Wärmeeintrag notwendig ist. Gerade in der Automobilindustrie durchlaufen Materialien vielfältige thermische Prozesse, die eine höchst präzise Steuerung erfordern, um ein optimales Endprodukt zu gewährleisten - z. B. beim Trocknen von Lacken oder Erwärmen von Kunststoffleisten. Weiterhin ist die Prozess- und Produkttemperatur in der Kunststoffindustrie, z. B. beim Thermoformen, Blasformen oder bei der Extrusion, ein wichtiger Faktor für die Qualität des Endprodukts.

Im Folgenden wird die Erfindung anhand der in den Figuren dargestellten Ausführungsbeispiele näher beschrieben und erläutert. Es zeigen:

FIG 1    einen Querschnitt durch eine Vorrichtung zum Messen eines Stroms,
FIG 2    eine schematische Darstellung des Stromverlaufs und
FIG 3    eine Draufsicht einer Leiteranordnung.

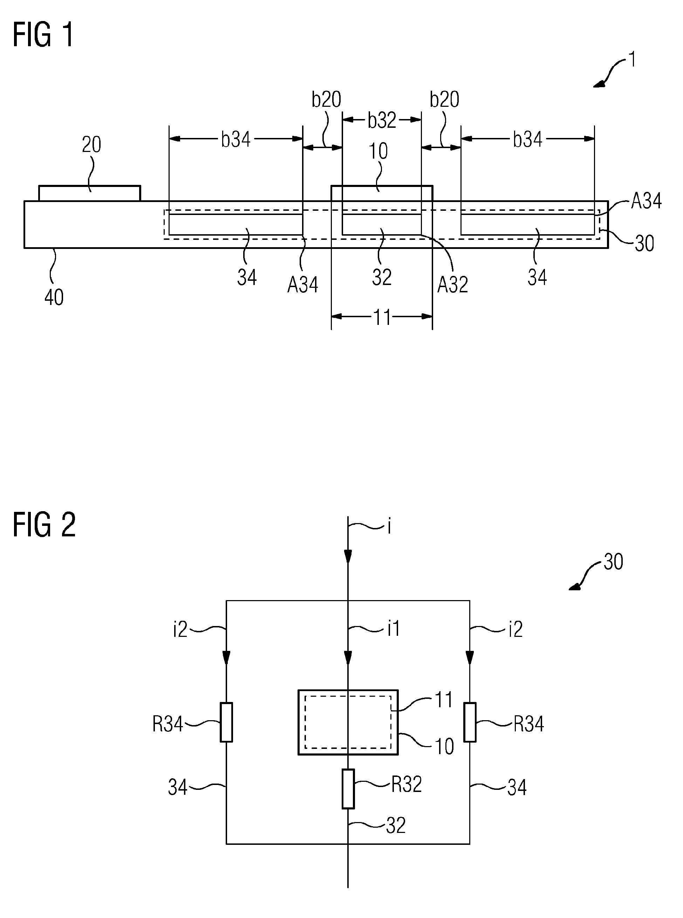

FIG 1 zeigt eine Ausführungsform einer Messvorrichtung 1. Gezeigt ist dabei ein Querschnitt durch eine Leiterplatte 40, in die eine Leiteranordnung 30 eingebracht ist. Die Leiteranordnung 30 besteht dabei aus einem Mess-Leiter 32 mit einer Breite b32 und einer Querschnittsfläche A32, sowie zwei Bypass-Leitern 34 mit jeweils einer Breite b34 und einer Querschnittsfläche A34. Ein Abstand b20 trennt den Mess-Leiter 32 von den Bypass-Leitern 34. Über dem Mess-Leiter 32 befindet sich eine Sensor-Anordnung 10. Die Sensor-Anordnung 10 weist einen Messbereich 11 auf. Die Sensor-Anordnung 10 kann dabei ein handelsüblicher Hall-Sensor-IC oder Hall-Effekt-Sensor-IC zur Strommessung sein. Darüber hinaus können auch weitere Sensoren zum Einsatz kommen, unter anderem magnetoresistive Sensoren die beispielsweise auf dem GMR-Effekt (englisch: **G**iant **M**agneto**R**esistance) beruhen. In dieser Schnittansicht ist der Mess-Leiter 32 vollständig im Messbereich 11 enthalten. Eine Auswerteeinheit 20 kann zur Auswertung von Mess-Signalen der Sensor-Anordnung 10 ausgebildet sein. Dabei kann es sich beispielsweise um einen Mikrocontroller handeln. Es ist aber ebenso denkbar, dass die Auswertung der Mess-Signale der Sensor-Anordnung 10 durch bereits vorhandene Prozessoren übernommen wird. Dadurch lässt sich die gezeigte Messvorrichtung einfach in bestehende Schaltungen integrieren. Die gezeigte Leiteranordnung 30 ist hier bezüglich des Mess-Leiters 32 symmetrisch aufgebaut. D.h. die beiden Bypass-Leiter 34 sind im gleichen Abstand b20 vom Mess-Leiter 32 angeordnet. Dies führt dazu, dass das Magnetfeld des Stromes, der durch die Bypass-Leiter 34 fließt, im Messbereich 11 minimal ist. Dies wirkt sich positiv auf die Messgenauigkeit der Vorrichtung 1 aus. Auf die Höhe der Leiteranordnung wird hier nicht explizit eingegangen, da diese über die Flächen A32, A34 mit abgedeckt ist und über die Leiteranordnung 30 gleich ist. Alternativ ist eine Leiteranordnung 30 denkbar, die unterschiedlich hohe Leiter aufweist. Auch hier kann über das Verhältnis der Querschnittsflächen A32, A34 die Aufteilung des Stromes festgelegt werden.

In FIG 2 ist schematisch eine Aufteilung eines Stromes i in einen Mess-Strom i1 und zwei Bypass-Ströme i2 zu sehen. Der Mess-Strom i1 fließt dabei in einem Mess-Leiter 32, der einen Leitungswiderstand R32 aufweist. Die Bypass-Ströme i2 fließen dabei zu gleichen Teilen durch die Bypass-Leiter 34, die jeweils einem Leitungswiderstand R34 aufweisen. Schematisch sind außerdem eine Sensor-Anordnung 10 und ihr Messbereich 11 über dem Mess-Leiter 32 angedeutet. Dadurch, dass die beiden Bypass-Widerstände R34 identisch sind, fließt durch beide Bypass-Leiter 34 der gleiche Strom i2. Der Mess-Strom i1 ist also abhängig vom Widerstand R32 des Mess-Leiters 32, den Bypass-Widerständen R34 der Bypass-Leiter 34 und dem zu messenden Strom i. Über die Verhältnisse der Widerstände zueinander kann folglich die Aufteilung des Stromes i auf den Mess-Strom i1 und die Bypass-Ströme i2 eingestellt werden.

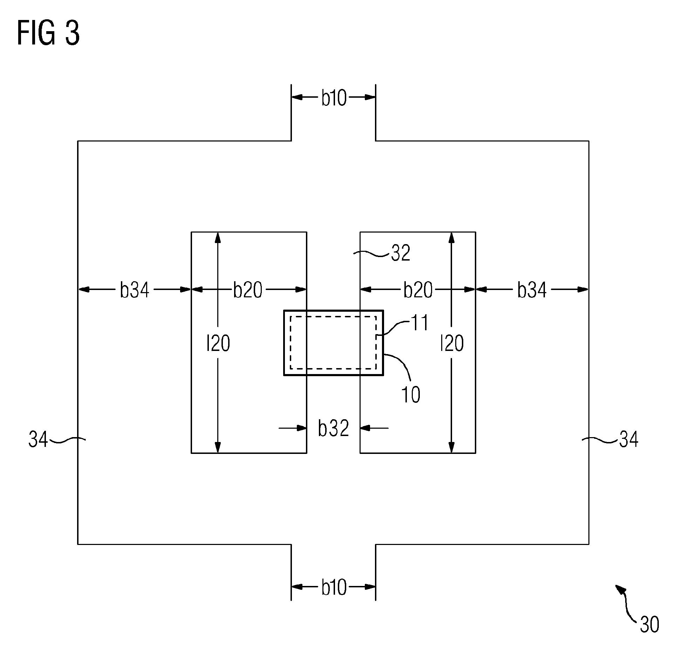

FIG 3 zeigt eine Draufsicht auf eine Leiteranordnung 30. Diese Leiteranordnung 30 könnte beispielsweise in oder auf ein PCB gedruckt sein. Es könnte sich dabei aber ebenso um eine Leiterplatte handeln die mittels weiteren gängigen Verfahren hergestellt wird. Wie schon aus den vorigen Figuren bekannt, weist die Leiteranordnung 30 einen Mess-Leiter 32 und zwei Bypass-Leiter 34 auf. Die Bypass-Leiter 34 haben dabei jeweils eine Breite b34, der Mess-Leiter 32 hat eine Breite b32. Über dem Mess-Leiter 32 befindet sich eine Sensor-Anordnung 10. Die Sensor-Anordnung 10 weist einen Messbereich 11 auf. Die Breite b10 bezeichnet die Breite der Zuleitung und der Ableitung. Durch die Breite der Zu-/Ableitung ist u.a. festgelegt, wie viel Strom der Leiteranordnung 30 zugeführt werden kann, daher sind diese entsprechend zu Dimensionieren oder alternativ entsprechende Klemmen oder andere Kontakte vorzusehen.

Wie in FIG 1 ist der Abstand zwischen den Bypass-Leitern als Breite b20 bezeichnet. Die Länge l20 bezeichnet die freie Länge des Mess-Leiters 32 sowie der Bypass-Leiter 34. Die Bypass-Leiter 34 sind anordnungsbedingt länger als der Mess-Leiter, da zu ihrer effektiven Länge auch die Breite b20 zählt, um die sie vom Mess-Leiter 32 entfernt sind. Stark vereinfacht kann über das Verhältnis der Breiten b32 und b34, bzw. direkt damit zusammenhängend über das Verhältnis der hier nicht gezeigten Querschnittsflächen A32 und A34, die Aufteilung des Stromes festgelegt werden.

Ist nun die Leiteranordnung 30 durchgehend aus dem gleichen Material, wie beispielsweise Kupfer, gefertigt, so ändert sich das Verhältnis der Widerstände R34 und R32 auch unter Temperaturschwankungen nicht. Bei Temperaturschwankungen verändern sich die Widerstände proportional zueinander und die Aufteilung des Stromes i in die Leiter 32, 34 verändert sich nicht. Darüber hinaus ist die symmetrische Aufteilung der Leiteranordnung 30 derart gewählt, dass im Messbereich 11 der Sensor-Anordnung 10 das Magnetfeld der Bypass-Leiter 34 minimal ist. So wird eine durchgehend hohe Messgenauigkeit erreicht, die auch durch Temperaturschwankungen nicht verändert wird.

Zusammenfassend betrifft die Erfindung eine Vorrichtung 1 zur Messung eines Stroms I, aufweisend eine Sensor-Anordnung 10 und eine Leiteranordnung 30, wobei die Leiteranordnung 30 einen Mess-Leiter 32 und zumindest einen Bypass-Leiter 34 aufweist und wobei die Leiteranordnung 30 zur Aufteilung des Stroms I in einen Mess-Strom I1 und mindestens einen Bypass-Strom 12 ausgebildet ist. Zur flexiblen und effizienten Messung eines Stroms wird vorgeschlagen eine Sensor-Anordnung 10 derart bezüglich der Leiteranordnung 30 anzuordnen, dass zumindest ein Teil des Mess-Leiters 32 in einem Messbereich 11 der Sensor-Anordnung 10 angeordnet ist und wobei der Mess-Leiter 32 zum Leiten des Mess-Stroms I1 ausgebildet ist und der Bypass-Leiter 34 zum Leiten des Bypass-Stroms 12 außerhalb des Messbereichs 11 der Sensor-Anordnung 10 ausgebildet ist.

**Patentansprüche**

1. Vorrichtung (1) zur Messung eines Stroms (I), aufweisend eine Sensor-Anordnung (10) und eine Leiteranordnung (30), wobei die Leiteranordnung (30) einen Mess-Leiter (32) und zumindest einen Bypass-Leiter (34) aufweist und wobei die Leiteranordnung (30) zur Aufteilung des Stroms (I) in einen Mess-Strom (I1) und mindestens einen Bypass-Strom (12) ausgebildet ist, wobei die Sensor-Anordnung (10) derart bezüglich der Leiteranordnung (30) angeordnet ist, dass zumindest ein Teil des Mess-Leiters (32) in einem Messbereich (11) der Sensor-Anordnung (10) angeordnet ist und wobei der Mess-Leiter (32) zum Leiten des Mess-Stroms (I1) ausgebildet ist und der Bypass-Leiter (34) zum Leiten des Bypass-Stroms (12) außerhalb des Messbereichs (11) der Sensor-Anordnung (10) ausgebildet ist.

2. Vorrichtung nach Anspruch 1, wobei die Sensor-Anordnung (10) bezogen auf die Leiteranordnung (30) derart angeordnet ist, dass ein Magnetfeld des zumindest einen stromdurchflossenen Bypass-Leiters (34) im Messbereich (11) der Sensor-Anordnung (10) minimal ist.

3. Vorrichtung nach einem der vorhergehenden Ansprüche, wobei der Mess-Leiter (32) und der zumindest eine Bypass-Leiter (34) gleiche oder ähnliche temperaturabhängige Materialeigenschaften aufweisen.

4. Vorrichtung nach einem der vorhergehenden Ansprüche, wobei das Verhältnis einer ersten Querschnittsfläche (A32) des Mess-Leiters (32) zu einer zweiten Querschnittsfläche (A34) des Bypass-Leiters (34) in Abhängigkeit vom maximal zu messenden Strom und in Abhängigkeit des von der Sensor-Anordnung (10) maximal erfassbaren Stroms gewählt ist.

5. Vorrichtung nach einem der vorhergehenden Ansprüche, wobei die Leiteranordnung (30) in oder auf eine Leiterplatte, insbesondere in oder auf eine nach einem PCB-Verfahren gefertigte Leiterplatte, integriert ist.

6. Vorrichtung nach einem der vorhergehenden Ansprüche, wobei die Leiteranordnung (30) symmetrisch bezüglich des Mess-Leiters (32) aufgebaut ist.

7. Vorrichtung nach einem der vorhergehenden Ansprüche, wobei der Mess-Leiter (32) mittig zwischen zwei Bypass-Leitern (34) angeordnet ist.

8. Vorrichtung nach einem der vorhergehenden Ansprüche, wobei mindestens zwei Bypass-Leiter (34) thermisch miteinander gekoppelt sind.

9. Vorrichtung nach einem der vorhergehenden Ansprüche, wobei mindestens der Mess-Leiter (32) und ein Bypass-Leiter (34) thermisch miteinander gekoppelt sind.

10. Vorrichtung nach einem der vorhergehenden Ansprüche, wobei die Sensor-Anordnung (10) als eine Hall-Sensor-Anordnung ausgebildet ist.

11. Vorrichtung nach einem der vorhergehenden Ansprüche, wobei die Sensor-Anordnung (10) als eine GMR-Sensor-Anordnung ausgebildet ist.

12. Heizungssystem aufweisend eine Vorrichtung nach einem der Ansprüche 1 bis 11 sowie mindestens ein Heizelement und eine Heizungssteuerung.

# FIG 1

# FIG 2

FIG 3

**Europäisches Patentamt**
**European Patent Office**
**Office européen des brevets**

## EUROPÄISCHER RECHERCHENBERICHT

Nummer der Anmeldung

EP 15 18 4216

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 4 492 919 A (MILKOVIC MIRAN [US]) 8. Januar 1985 (1985-01-08) * Zusammenfassung; Abbildung 2a * * Spalte 1, Zeile 5 - Spalte 2, Zeile 37 * * Spalte 2, Zeile 61 - Spalte 4, Zeile 32 * ----- | 1-4,6-9, 12 | INV. G01R15/20 G01R15/14 |
| X | US 2013/015843 A1 (DOOGUE MICHAEL C [US] ET AL) 17. Januar 2013 (2013-01-17) * Zusammenfassung; Abbildung 1 * * Absätze [0004] - [0011], [0021], [0024] * ----- | 1,3-5, 10-12 | |
| A | EP 2 899 552 A2 (HITACHI METALS LTD [JP]) 29. Juli 2015 (2015-07-29) * Zusammenfassung; Abbildungen 1-6b * * Absätze [0002] - [0004], [0006] - [0009], [0019], [0022] * ----- | 1-12 | |

**RECHERCHIERTE SACHGEBIETE (IPC)**

G01R

Der vorliegende Recherchenbericht wurde für alle Patentansprüche erstellt

| Recherchenort | Abschlußdatum der Recherche | Prüfer |
|---|---|---|
| München | 15. Februar 2016 | Kleiber, Michael |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

 & : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 15 18 4216

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-02-2016

| Im Recherchenbericht angeführtes Patentdokument | | Datum der Veröffentlichung | Mitglied(er) der Patentfamilie | | | Datum der Veröffentlichung |
|---|---|---|---|---|---|---|
| US 4492919 | A | 08-01-1985 | KEINE | | | |
| US 2013015843 | A1 | 17-01-2013 | DE | 112012002932 | T5 | 24-04-2014 |
| | | | JP | 2014522980 | A | 08-09-2014 |
| | | | US | 2013015843 | A1 | 17-01-2013 |
| | | | WO | 2013015956 | A1 | 31-01-2013 |
| EP 2899552 | A2 | 29-07-2015 | EP | 2899552 | A2 | 29-07-2015 |
| | | | JP | 2015137894 | A | 30-07-2015 |
| | | | US | 2015204919 | A1 | 23-07-2015 |

EPO FORM P0461

Für nähere Einzelheiten zu diesem Anhang : siehe Amtsblatt des Europäischen Patentamts, Nr.12/82